# EUROPEAN PATENT APPLICATION

(11) **EP 2 420 915 A2**
(43) Date of publication of application: **22.02.2012**
(21) Application number: 11171104.0
(22) Date of filing: 22.06.2011
(51) Int. Cl.: G06F 1/28

(54) **Startup protection circuit for a processing unit and electronic device using the same**

(30) Priority: 18.08.2010 CN 201010256601
(71) Applicant: Hong Fu Jin Precision Industry (ShenZhen) Co., Ltd., Longhua Town, Bao'an District Shenzhen City Guangdong 518109 (CN); Hon Hai Precision Co., Ltd, Tu-cheng City, Taipei Hsien Taiwan, ROC (CN)
(72) Inventor: Wang, Tao, 518109 Shenzhen (CN)
(74) Representative: Gray, John James

(57) **Abstract**

A startup protection circuit (200) includes an initialization unit (10) and a protection unit (20). The initialization unit (10) generates a first level signal when initially receiving a supply voltage, which is larger than or equal to a predetermined voltage from a power source (400). The protection unit (20) generates the first level signal when the supply voltage is smaller than the predetermined voltage. A processing unit (300) is connected to the power source (400), and is initialized according to the first level signal. A related electronic device (100) is also provided.

## Description

### Field

The disclosed embodiments relate to electronic devices, and more particularly to an electronic device with a startup protection circuit.

### Background

Generally, an electronic device includes an initialization circuit and a processing unit, and the electronic device is powered by a supply voltage from a power source. The initialization circuit is used for initializing the processing unit, when the processing unit has initialized completely, the processing unit is ready for use.

However, sometimes, the supply voltage may be too low. In this situation, the processing unit may still start up and try to operate in some way. In such situation, the processing unit may malfunction because of trying to operate with low voltage.

Therefore, there is room for improvement in the art.

### SUMMARY

According to an exemplary embodiment of the invention, a startup protection circuit includes an initialization unit and a protection unit. The initialization unit generates a first level signal when initially receiving a supply voltage, which is larger than or equal to a predetermined voltage from a power source. The protection unit generates the first level signal when the supply voltage is smaller than the predetermined voltage. A processing unit is connected to the power source, and is initialized according to the first level signal. A related electronic device is also provided. Therefore, when the supply voltage is smaller than the predetermined voltage, the processing unit cannot be activated.

### BRIEF DESCRIPTION OF THE DRAWINGS

Many aspects of the embodiments can be better understood with reference to the following drawings. The components in the drawings are not necessarily drawn to scale, the emphasis instead being placed upon clearly illustrating the principles of the present embodiments. Moreover, in the drawings, like reference numerals designate corresponding parts throughout two views.

FIG. 1 is a block diagram of an electronic device in accordance with an exemplary embodiment.

FIG. 2 is a circuit diagram of the electronic device of FIG. 1.

### DETAILED DESCRIPTION

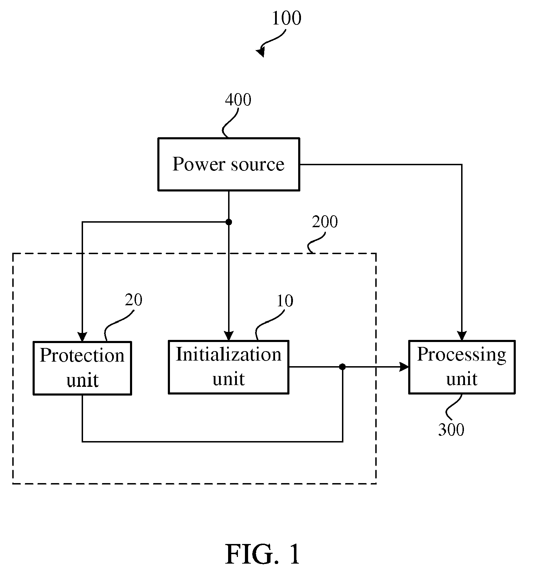

Referring to FIG. 1, an electronic device 100 includes a startup protection circuit 200, a processing unit 300, and a power source 400. The power source 400 provides a supply voltage to the startup protection circuit 200 and the processing unit 300. In other embodiments, the power source 400 is not included in the electronic device 100.

The startup protection circuit 200 includes an initialization unit 10 and a protection unit 20. The initialization unit 10 is connected to the processing unit 300. The initialization unit 10 generates a first level signal when initially receiving the supply voltage which is larger than or equal to a predetermined voltage. After the first level signal is generated for a predetermined time period, the initialization unit 10 generates a second level signal.

The processing unit 300 is initialized according to the first level signal, during the predetermined time period, the processing unit 300 may execute built-in software programs. After the predetermined time period, the processing unit 300 has initialized completely. Therefore, the processing unit 300 is ready for use according to the second level signal. In this embodiment, the first level signal is a low level voltage signal, and the second level signal is a high level voltage signal.

The protection unit 20 is connected to the processing unit 300. The protection unit 20 generates the first level signal when the supply voltage is smaller than the predetermined voltage, and stops generating the first level signal when the supply voltage is larger than or equal to the predetermined voltage. Therefore, when the supply voltage is smaller than a predetermined voltage, the processing unit 300 cannot receive the second level signal from the initialization unit 10, thus the processing unit 300 cannot be activated and cannot perform error operations.

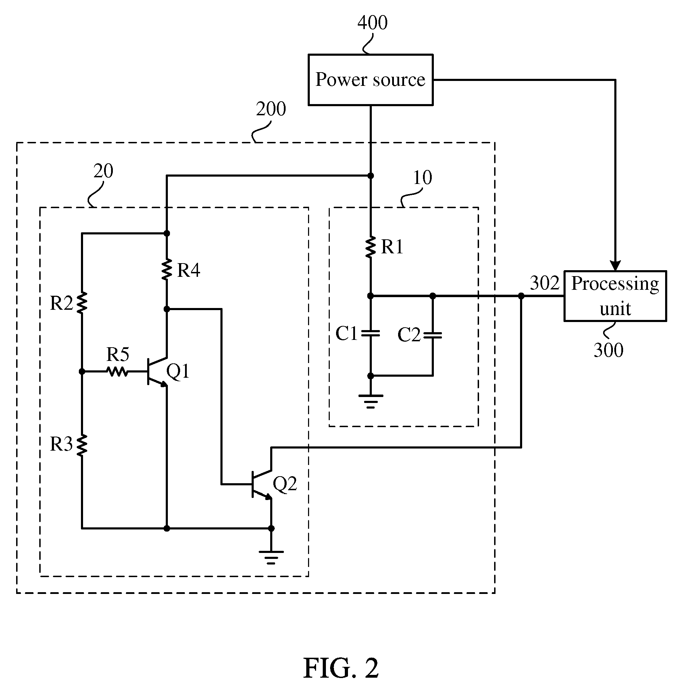

Referring to FIG. 2, the initialization unit 10 includes a first resistor R1, a first capacitor C1, and a second capacitor C2. One end of the first resistor R1 is connected to the power source 400, the other end of the first resistor R1 is grounded through the first capacitor C1. The processing unit 300 includes an initializing pin 302 for receiving the first level signal and the second level signal, the initializing pin 302 is connected between the first resistor R1 and the first capacitor C1. One end of the second capacitor C2 is connected to the initializing pin 302, the other end of the second capacitor C2 is grounded.

The protection unit 20 includes a second resistor R2, a third resistor R3, a fourth resistor R4, a fifth resistor R5, a first transistor Q1 and a second transistor Q2. The second resistor R2 and the third resistor R3 are connected in series between the power source 400 and ground. Abase of the first transistor Q1 is connected between the second resistor R2 and the third resistor R3 through the fifth resistor R5, an emitter of the first transistor Q1 is grounded, a collector of the first transistor Q1 is connected to the power source 400 through the fourth resistor R4. The base of the second transistor Q2 is connected to the collector of the first transistor Q1, the emitter of the second transistor Q2 is grounded, the collector of the second transistor Q2 is connected to the initializing pin 302. In this embodiment, the first transistor Q1 and the second transistor Q2 are npn type transistors.

The principle of the electronic device 100 is as follows:

When the electronic device 100 initially receives the supply voltage from the power source 400, the base of the first transistor Q1 is pulled high, and the first transistor Q1 is turned on. The base of the second transistor Q2 is pulled low, and the second transistor Q2 is turned off. The initializing pin 302 receives a low level voltage signal, and is initialized. The supply voltage charges up the first capacitor C1 and the second capacitor C2 through the first resistor R1, the processing unit 300 has initialized completely after a predetermined time period T, T is calculated by the formula: *T* = *R*1 x (Cl + C2). The initializing pin 302 receives a high level voltage signal, and the processing unit 300 is ready for use.

When the supply voltage from the power source 400 is smaller than the predetermined voltage, the base of the first transistor Q1 is pulled low, and the first transistor Q1 is turned off. The base of the second transistor Q2 is pulled high, and the second transistor Q2 is turned on. The initializing pin 302 also receives a low level voltage signal, and is initialized. Because the initializing pin 302 receives the low level voltage signal when the supply voltage is smaller than the predetermined voltage, the processing unit 300 cannot be activated.

Further alternative embodiments will become apparent to those skilled in the art without departing from the spirit and scope of what is claimed. Accordingly, the present invention should be deemed not to be limited to the above detailed description, but rather only by the claims that follow and equivalents thereof.

## Claims

1. A startup protection circuit for receiving a supply voltage from a power source and initializing a processing unit, the startup protection circuit comprising:
an initialization unit for generating a first level signal when initially receiving the supply voltage which is larger than or equal to a predetermined voltage; and
a protection unit for generating the first level signal when the supply voltage is smaller than the predetermined voltage;
wherein the processing unit is connected to the power source, and is initialized according to the first level signal.

2. The startup protection circuit as claimed in claim 1, wherein the initialization unit generates a second level signal when having received the supply voltage which is larger than or equal to the predetermined voltage for a predetermined time period, after the predetermined time period, the processing unit has initialized completely and is activated according to the second level signal.

3. The startup protection circuit as claimed in claim 1 or 2, wherein the protection unit stops generating the first level signal when the supply voltage is larger than or equal to the predetermined voltage.

4. The startup protection circuit as claimed in claim 2, wherein the first level signal is a low level voltage signal, the second level signal is a high level voltage signal.

5. The startup protection circuit as claimed in claim 2 or 4, wherein the initialization unit comprises a first resistor and a first capacitor, one end of the first resistor is connected to the power source, the other end of the first resistor is grounded through the first capacitor, the processing unit comprises an initializing pin for receiving the first level signal and the second level signal, the initializing pin is connected between the first resistor and the first capacitor.

6. The startup protection circuit as claimed in claim 5, wherein the initialization unit further comprises a second capacitor, one end of the second capacitor is connected to the initializing pin, the other end of the second capacitor is grounded.

7. The startup protection circuit as claimed in any of claims 2, 4, 5 and 6, wherein the protection unit comprises a first transistor and a second transistor, the processing unit comprises an initializing pin for receiving the first level signal and the second level signal; when the supply voltage is smaller than a predetermined voltage, the first transistor is turned on, the second transistor is turned off, and the initializing pin receives the first level signal.

8. The startup protection circuit as claimed in claim 7, wherein the protection unit further comprises a second resistor, a third resistor, and a fourth resistor, the second resistor and the third resistor are connected in series between the power source and ground, a base of the first transistor is connected between the second resistor and the third resistor, an emitter of the first transistor is grounded, a collector of the first transistor is connected to the power source through the fourth resistor, the base of the second transistor is connected to the collector of the first transistor, the emitter of the second transistor is grounded, the collector of the second transistor is connected to the initializing pin.

9. The startup protection circuit as claimed in claim 8, wherein the protection unit further comprises a fifth resistor, one end of the fifth resistor is connected between the second resistor and the third resistor, the other end of the fifth resistor is connected to the base of the first transistor.

10. The startup protection circuit as claimed in any of claims 7 to 9, wherein the first transistor and the second transistor are NPN type transistors.

11. An electronic device powered by a supply voltage from a power source, the electronic device comprising:
an initialization unit for generating a first level signal when initially receiving the supply voltage which is larger than or equal to a predetermined voltage;
a protection unit for generating the first level signal when the supply voltage is smaller than the predetermined voltage; and
a processing unit; wherein the processing unit is initialized according to the first level signal.

12. The electronic device as claimed in claim 11, wherein the initialization unit generates a second level signal when having received the supply voltage which is larger than or equal to the predetermined voltage for a predetermined time period, after the predetermined time period, the processing unit has initialized completely and is activated according to the second level signal.

13. The electronic device as claimed in claim 11 or 12, wherein the protection unit stops generating the first level signal when the supply voltage is larger than or equal to the predetermined voltage.

14. The electronic device as claimed in claim 12, wherein the first level signal is a low level voltage signal, the second level signal is a high level voltage signal.

15. The electronic device as claimed in claim 12 or 14, wherein the initialization unit comprises a first resistor and a first capacitor, one end of the first resistor is connected to the power source, the other end of the first resistor is ground through the first capacitor, the processing unit comprises an initializing pin for receiving the first level signal and the second level signal, the initializing pin is connected between the first resistor and the first capacitor.
